Europäisches Patentamt

European Patent Office (11) Publication number: **0 182 360**

Office européen des brevets **B1**

## EUROPEAN PATENT SPECIFICATION

(45) Date of publication of patent specification: 28.06.89

(21) Application number: 85114709.0

(22) Date of filing: 19.11.85

(51) Int. Cl.⁴: **H 01 L 21/263,** H 01 J 37/30, G 03 F 7/20

(54) A system for continuously exposing desired patterns and their backgrounds on a target surface.

(30) Priority: 22.11.84 JP 247425/84
22.11.84 JP 247426/84
22.07.85 JP 161519/85

(43) Date of publication of application:
28.05.86 Bulletin 86/22

(45) Publication of the grant of the patent:
28.06.89 Bulletin 89/26

(84) Designated Contracting States:
DE FR GB

(56) References cited:
EP-A-0 043 863
EP-A-0 081 283
DE-A-2 755 399
US-A-4 392 058

IBM JOURNAL OF RESEARCH AND
DEVELOPMENT, vol. 21, no. 6, November 1977,
New York. MAUER et al.: "Electron Optics of an
Electron-Beam Lithographic System", pages
514-521

(73) Proprietor: Toshiba Machine Company Limited
2-11, 4-chome Ginza Chuo-ku
Tokyo (JP)

(72) Inventor: Kasahara, Izumi
17-18, Yutaka-cho
Numazu-shi Shizuoka-ken (JP)
Inventor: Kawaughi, Yasunobu
1-6-8, Masushidai
Fussa-shi Tokyo (JP)
Inventor: Suzuki, Yoshio
101-50, Okaisshiki
Numazu-shi Shizuoka-ken (JP)

(74) Representative: Sajda, Wolf E., Dipl.-Phys. et al
MEISSNER, BOLTE & PARTNER
Widenmayerstrasse 48 Postfach 86 06 24
D-8000 München 86 (DE)

Courier Press, Leamington Spa, England.

## Description

The present invention relates to a system for continuously exposing desired patterns and their backgrounds on a target surface, comprising: an electron gun for emitting an electron beam; blanking means for blanking the electron beam, which includes a blanking electrode and an aperture member; generating means for generating a blanking signal to be supplied to the blanking electrode, the electron beam being intercepted when the blanking signal is applied to the blanking electrode; focussing means for focussing the electron beam on the surface of the target, which includes an objective and condenser lens for converging the electron beam on the target surface; defocussing means for defocussing the electron beam on the target surface; and deflecting means for deflecting the electron beam to scan the target surface with the electron beam.

Various electron beam lithography systems have recently been developed which delineate a fine pattern on the surface of a target, such as a semiconductor wafer, mask substrate, etc., by means of an electron beam. Since patterns have become finer and finer, electron beam lithography systems need to maintain their exposure accuracy in spite of a proximity effect resulting from the electrons scattered in the substrate and in a resist film formed on the surface of the substrate, and from other causes.

Methods of correction of the proximity effect applicable to the electron beam lithography systems include:

(1) To correct the dose of electron beams applied to the substrate;

(2) To correct the shape of the pattern formed on the substrate; and

(3) To form a multilayer resist film on the substrate.

If method (1) is applied to the lithography systems, massive calculation must be performed to obtain the corrected value. Moreover, method (1) cannot be applied to lithography systems of a raster-scanning type. If method (2) is applied, the shapes of pattern must be subjected to a very fine adjustment. Method (3) complicates the processes of coating a resist film and developing patterns.

Thereupon, a fourth method has been proposed. In this method, a background region of the substrate is exposed by a defocused electron beam whose beam current is lower than that of the electron beam for delineating the pattern. This method helps to maintain dimensions of the pattern, despite the electrons scattered from the substrate.

In the prior art electron beam lithography systems, if an electron beam is incident on the resist film formed on the substrate surface, the energy absorbed by the resist film consists of a first component produced by forwardly scattered electrons and a second component produced by backwardly scattered electrons. The forwardly scattered electrons include the electrons incident on the resist film and the electrons scattered within the resist film. The backwardly scattered electrons are ones scattered back from the substrate. The first component spread within a range of 0,1 to 0,2 µm, and the second component within a range of 1 to 10 µm. These ranges change according to the acceleration of the electron beam. After a pattern has been delineated, the spread of the second component influences the quantity of energy absorbed by a certain portion of the resist film. Due to the spread of the second component, the pattern formed on the substrate cannot have the desired dimensions.

In the fourth method, the background is repeatedly exposed by a defocussed electron beam which provides the same absorbed energy quantity distribution as does the second component. Therefore the sum of the second component of the electron beam and a component of the defocused electron beam is uniformly distributed on the surface of the substrate. Thus, the influence of the second component on the pattern dimensions is reduced. Since the spread of the first component can fully be suppressed to 0,1 µm or less by, for example, increasing the acceleration voltage, the fourth method can reduce the proximity effect and therefore, provide an accurate pattern.

If the fourth method is applied to the lithography systems in practical use, however, the pattern must be first delineated by an electron beam and the background must then be exposed by another electron beam defocussed for correction. This would reduce the exposure throughput to half or less.

A system as mentioned above is known from DE—A—2 755 399, but on the one hand the defocussing means for forming a beam for background delineation is located at a totally different position, on the other hand, different means are used for weakening the strength of a beam for background delineation in this known structure. While an Einzel lens is used as a defocussing means, the corresponding lens is located between the objective and the electron gun so that the known structure is of limited efficiency.

In the known structure according to DE—A—2 755 399 the defocussing means is located within an electron beam optical lens barrel over an objective such that it is situated below a magnetic lens. Accordingly, the position of a beam on the target is greatly displaced due to the action of the electrostatic lens forming the defocussing means resulting in that the system fails to perform a desired highly-accurate proximity-effect-correction even though a defocussing effect is obtained.

In the known system according to DE—A—2 755 399 an asterisk or star-shaped aperture is used as an objective aperture. The objective aperture is primarily directed to limiting the beam, and it results therefrom that the configuration of the asterisk aperture causes a degradation of the regular beam characteristic. Consequently, this feature of the structure fails to achieve a proximity effect correction with the necessary high accuracy as desired. Moreover, this known system is silent as to any concept of using a blanking operation as means for weakening the intensity of an electron beam so that the background delineation may be carried out in this manner.

The system according to EP—A—0081283 uses two electron guns in an electron beam exposure apparatus in order to delineate a pattern and a background. A similar system is also known from US—A—4 392 058 wherein different means are used for delineating a pattern on the one hand and a respective background on the other hand.

Document EP—A—0043863 discloses a method for compensating the proximity effect, however, in this system they make use of double exposure using corresponding masks for obtaining the desired defocussing effect. An electron object of an electron-beam lithographic system is described in general in IBM Journal of Research and Development, Vol. 21, November 1977, pages 514 to 521, but the disclosed system is silent as to any specific concept aiming at proximity effect correction and the use of blanking, respectively.

The object underlying the invention is to provide for a system for continuously exposing desired patterns and their backgrounds on a target surface which is capable of correcting a proximity effect without lowering the desired exposures so that the accuracy of pattern formation is improved both with respect to patterns and corresponding background.

The system according to the invention is characterized in that the generating means is capable of generating a voltage signal to be supplied to the blanking electrode, wherein a part of the electron beam is intercepted by the aperture member attached to the condenser lens when the voltage signal is applied to the blanking electrode so that the beam current of the electron beam is reduced, in that the defocussing means is located between the objective and the target surface and includes an electrostatic lens for converging the electron beam on the target surface, and in that the defocussing means is energized when the voltage signal is applied to the blanking electrode, the pattern being delineated by the focussed electron beam, and the background being delineated by the defocussed electron beam on the target surface, the switching between the focussed and the defocussed electron beam being accomplished by turning that electrostatic lens on or off.

According to a further development of the system according to the invention the electrostatic lens comprises a first electrode, which functions as an electrode of the objective, and second and third electrodes.

According to a further development, the system according to the invention is characterized by second generating means for generating a defocussing signal to be applied to the second electrode of the electrostatic lens.

Preferably, the first and third electrodes of the electrostatic lens are maintained at the same potential.

Also it is preferred that the second and third electrodes of the electrostatic lens have different potentials.

In a specific embodiment according to the invention the electrostatic lens is an Einzel lens.

According to a further development of the invention the system is characterized by a memory containing stored pattern data, and means for giving command signals to the focussing means, the defocussing means, the deflecting means and the blanking means in accordance with the data delivered from the memory.

A considerable advantage of the system according to the invention resides in that there is only a small structural difference between the electron lens system for delineating patterns and for delineating backgrounds which is achieved by locating the defocussing means in the specified manner between the objective and the target. On the one hand, when delineating patterns, the electrostatic lens constituting the defocussing means is deenergized. On the other hand, when delineating background, the electrostatic lens between the objective and the target is energized.

In the system according to the invention the optical arrangement extending from the electron gun to the objective remains one and the same and is not changed in both cases when delineating patterns or background. The only difference is that the electrostatic lens is activated between the objective and the target when a background is to be delineated. It results from this very arrangement that the electron lens system can easily be accessed for adjustment. Another advantage of the system according to the invention is that—after delineating a pattern, a background can be delineated at a higher speed. Moreover, the system according to the invention is advantageous in that it is relatively simple in structure and can easily be handled. Also, any patterns and backgrounds can be delineated with high precision as required in practice.

This invention can be more fully understood from the following detailed description when taken in conjunction with the accompanying drawings, in which:

Fig. 1 is a schematic view showing a lithography system;

Fig. 2 is a schematic view showing another lithography system;

Fig. 3 is a schematic view showing a further lithography system;

Fig. 4 is a schematic view showing a still further lithography system; and

Fig. 5 is a schematic view showing a lithography system according to an embodiment of the invention.

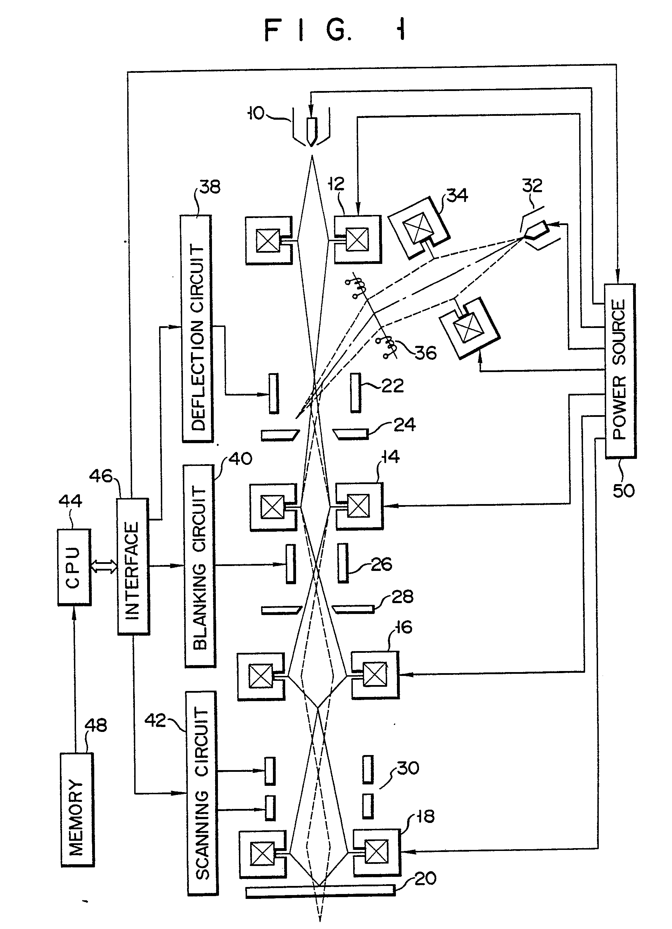

Fig. 1 is a schematic view of a lithography system using electron beams. Below a first electron gun 10 for emitting a first electron beam, there are arranged first, second and third condenser lenses 12, 14 and 16, an objective lens 18, and a substrate or target 20 on which a pattern is delineated by electron beams. A deflector 22 is disposed between the first and second condenser lenses 12 and 14 and in the vicinity of an electron beam path along which a crossover image of electron beams is formed. The deflector 22 serves to deflect electron beams, thereby selecting an electron beam to be incident on the target 20. Disposed between the deflector 22 and the second condenser lens 14 is a plate 24 on which a nonselected electron beam is to impinge. A blanking electrode 26 for deflecting the electron beams is provided between the second and third condenser lenses 14 and 16. Disposed between the blanking electrode 26 and the third condenser lens 16 is a blanking plate 28 on which the deflected electron beams are to impinge. Arranged between the third condenser lens 16 and the objective lens 18 is a scanning deflector 30 for deflecting the electron beams in an X-direction (horizontal direction of Fig. 1) and in a Y-direction (perpendicular to the drawing plane of Fig. 1) above the surface of the target 20.

Above the deflector 22, as shown in Fig. 1, there are arranged a second electron gun 32 for emitting a second electron beam, a fourth condenser lens 34 for converging the second electron beam, and a deflecting coil 36 for deflecting the second electron beam. The second electron beam emitted from the second electron gun 32 is directed toward the center of the deflector 22 via the fourth condenser lens 34 and the deflecting coil 36, and caused to cross the first electron beam within the deflector 22. As shown in Fig. 1, these electron lenses and other components are connected to a power source 50 to be driven by power therefrom.

There will now be described the way the target 20 is exposed by the electron beam lithography system shown in Fig. 1 using the raster scanning method.

In delineating a pattern, the deflector 22 is kept from being supplied with zero voltage from a deflection circuit 38. In this case, the first electron beam emitted from the first electron gun 10, as indicated by full line in Fig. 1, is converged by an electrooptical system, and then focused on the surface of the target 20. Namely, the first, second and third condenser lenses 12, 14 and 16 and the objective lens 18 are adjusted so that a crossover image of a predetermined size is formed on the target 20 by using a predetermined beam current. Thus, while the deflecting voltage is not being applied to the deflector 22, the second electron beam emitted from the second electron gun 32 impinges on the plate 24, so that only the first electron beam is directed toward the surface of the target 20.

In delineating a background, the deflecting voltage is applied from the deflection circuit 38 to the deflector 22. As a result, the first electron beam is deflected to be caused to impinge on the plate 24 without being directed toward the target 20. As indicated by broken line in Fig. 1, the second electron beam is deflected to be directed toward the surface of the target 20. In this case, the second electron beam is adjusted by the fourth condenser lens 34 so as to be defocused at the surface of the target 20 or focused on a point below the target 20, and to have a predetermined diameter greater than that of the first electron beam on the surface of the target 20, and a predetermined current lower than that of the first electron beam. Thus, the background is exposed to the second electron beam.

During exposure, pattern data in a memory 48 are successively processed by a CPU 44, which gives commands to the deflection circuit 38, a scanning circuit 42, and a blanking circuit 40 through an interface 46. In response to the pattern data, the deflection circuit 38, the blanking circuit 40 and the scanning circuit 42 deliver a deflection signal, a blanking signal, and a scanning signal, respectively.

In accordance with the deflection signal, the deflector 22 selects the electron beam to be directed toward the target 20. The first or second electron beam selected by the deflector 22 is deflected in the X- and Y-direction above the target 20. Thus, the pattern and background are delineated for each line on the surface of the target 20 by the first and second electron beams.

The CPU 44 controls the change of the electron beam to be incident on the surface of the target 20, from the first electron beam to the second one. In accordance with the pattern data in the memory 48, the CPU 44 supplies data to the deflection circuit 38 through the interface 46, and the deflection circuit 38 then delivers a deflection signal. In response to this deflection signal, voltage is applied to the deflector 22, so that the electron beams emitted from the first and second electron guns 10 and 32 are deflected. In consequence, the electron beam to be incident on the surface of the target 20 is shifted from the first electron beam to the second. When scanning the surface of the target 20 once with the electron beam by means of the lithography system, therefore, the deflector 22 is switched on or off by the CPU 44, so that pattern portions of a line are delineated by the first electron beam, while background portions of the same line are exposed to the second electron beam. Thus, such as lithography system doe not require to scan the target along the same scanning line twice by using different beams. Accordingly, the reduction of exposure accuracy due to the proximity effect can be prevented without lowering the delineation throughput.

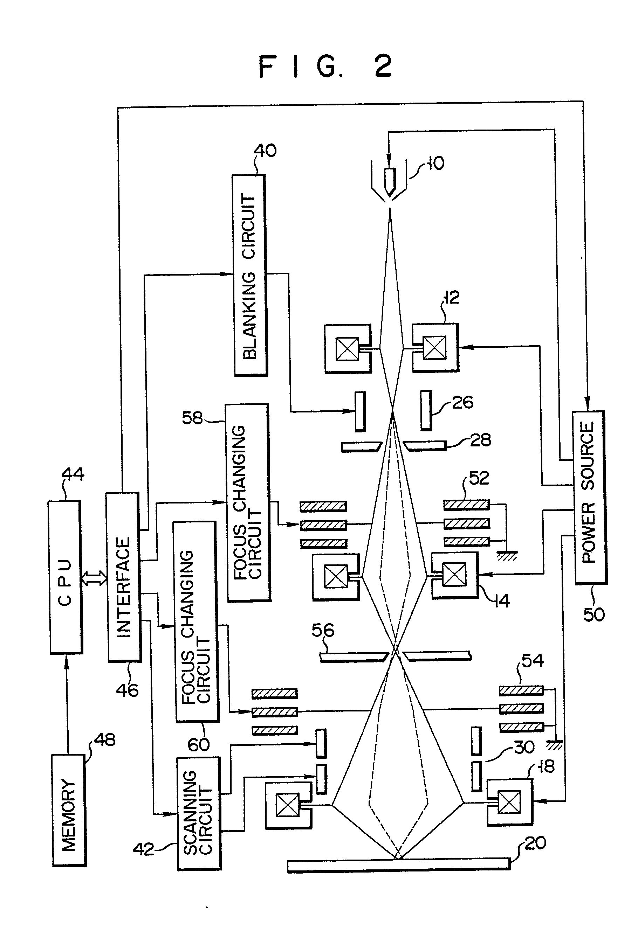

Fig. 2 shows a further lithography system. In Fig. 2, like reference numerals are used to designate like members as shown in Fig. 1, and a description of those members is omitted herein.

Unlike the first system, this second lithography system is provided with a first electron gun 10 only. Disposed between the plate 28 and the second condenser lens 14 is a first high-speed variable-focus lens 52 for converging the electron beam and changing its focal length at high speed. Disposed between the second condenser lens 14 and the beam-scanning deflector 30 is an aperture mask 56 for restricting the current for the electron beam while voltage is applied to the first high-speed variable-focus lens 52, and a second high-speed variable-focus lens 54 for converging the electron beam and changing its focal length at high speed. Voltage is applied to the first high-speed variable-focus lens 52 in response to a focus change signal from a focus changing circuit 58, while voltage is applied to the second high-speed variable-focus lens 54 in response to a focus change signal from another focus changing circuit 60.

The operation of the lithography system according to Fig. 2 will now be described. In delineating a pattern on the surface of the target 20, no voltage is applied to the high-speed variable-focus lenses 52 and 54, the condenser lenses 12, 14 and the objective lens 18 are adjusted so that the first electron beam emitted from the electon gun 10 is focussed on the surface of the target 20, as indicated by full lines in Fig. 2. At the same time, the focussed beam diameter on the target 20 and the beam current are adjusted to predetermined values. A scanning signal from the CPU 44 is supplied to the scanning circuit 42 through the interface 46, and voltage is applied to the scanning deflector 30 in response to the scanning signal from the scanning circuit 42. As the scanning deflector 30 is actuated in this manner, the first electron beam is deflected to form the desired pattern on the target 20.

In exposing a background, focus change signals from the CPU 44 are supplied to the focus changing circuits 58 and 60 through the interface 46, and voltage is applied to the high-speed variable-focus lenses 52 and 54 in response to the focus change signals. As a result, the focus of the electron beam is placed on a point above the surface of the target 20, so that a defocussed second electron beam is generated, as indicated by broken lines in Fig. 2. The second electron beam which is incident on the surface of the target 20 is greater in diameter and lower in current than the first electron beam. In this manner, the background region is exposed to the second electron beam.

Thus, unlike the system of Fig. 1 the lithography system according to Fig. 2 can produce either of the first and second electron beams by switching on or off the high-speed variable-focus lenses 52 and 54 without the use of the second electron gun 32.

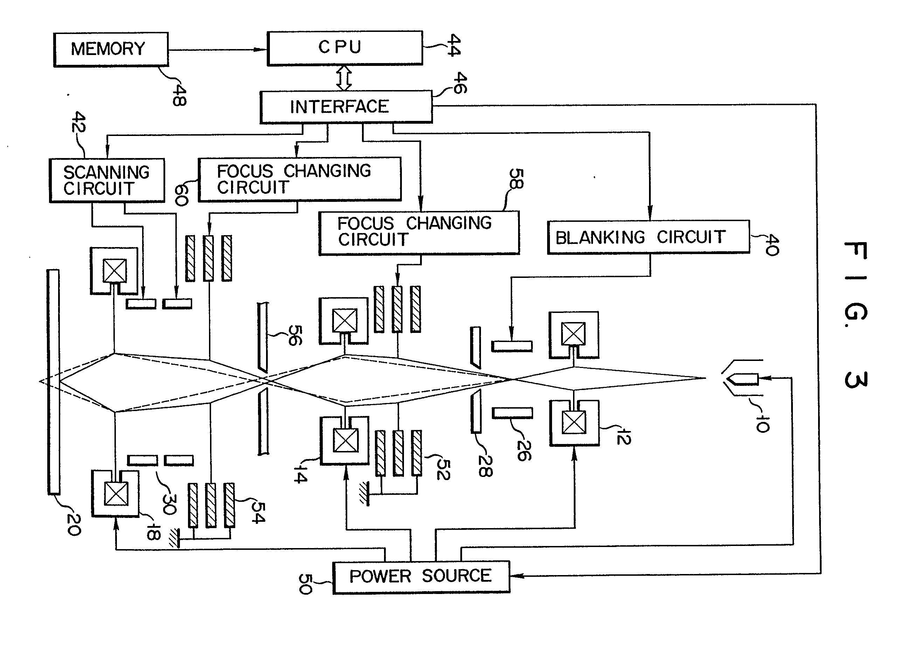

Fig. 3 is a schematic view of a further lithography system. This lithography system has substantially the same construction as the lithography system of Fig. 2. The former differs from the latter only in the on-off conditions of the high-speed variable-focus lenses. Namely, in delineating a pattern on the surface of the target 20, in the lithography system of Fig. 3, voltage is applied to the high-speed variable-focus lenses 52 and 54, and the first electron beam behaves as indicated by full lines in Fig. 3. In exposing a background on the surface of the target 20, on the other hand, no voltage is applied to the variable-focus lenses 52 and 54, and the second electron beam behaves as indicated by broken lines in Fig. 3.

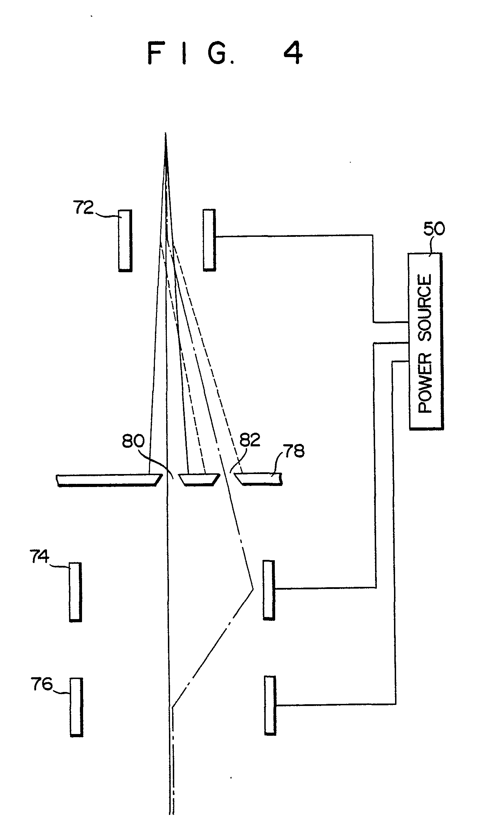

Fig. 4 is a schematic view showing principal parts of a still further lithography system, in which the electron gun, condenser lens, objective lens, CPU, high-speed variable-focus lenses, etc., are omitted. As shown in Fig. 4, the lithography system comprises deflectors 72, 74 and 76 each including an electrostatic lens. An aperture mask 78 for limiting beam current is disposed between the deflectors 72 and 74. The aperture mask 78 has a first aperture 80 and a second aperture 82 smaller in diameter than the first aperture 80. In delineating a pattern on the surface of the target (not shown), no voltage is applied to the deflectors 72, 74 and 76, and no voltage to the high-speed variable-focus lenses (not shown) either. Accordingly, the electron beam emitted from the electron gun passes through the first aperture 80 and is focussed by the objective lens to form a first electron beam as indicated by full lines in Fig. 4, which is incident on the surface of the target. In exposing a background, voltage is applied to the deflectors 72, 74 and 76, and also to the high-speed variable-focus lenses. In this case, the electron beam emitted from the electron gun is deflected by the deflector 72, as indicated by broken lines in Fig. 4, and passes through the second aperture 82. Further, the electron beam is deflected successively by the deflectors 74 and 76 to be directed toward the surface of the target, and is defocussed by the high speed variable-focus lens. Thus, since the second aperture 82 through which the second electron beam passes is narrower than the first aperture 80, that part of the second beam intercepted by the aperture mask 78 is greater than that of the first electron beam. As a result, the beam current of the second electron beam is made less than that of the first electron beam, and the diameter of the second electron beam which is incident on the surface of the target is increased by the agency of the high-speed variable-focus lenses. Thus, the first electron beam for delineating the pattern and the second electron beam for exposing the background may be obtained by switching on or off the deflectors 72, 74 and 76 and the high-speed variable-focus lenses.

In the described systems, the high-speed variable-focus lenses may be three in number, and their locations may be changed as required. The positions of the apertures 78 may also be changed according to circumstances.

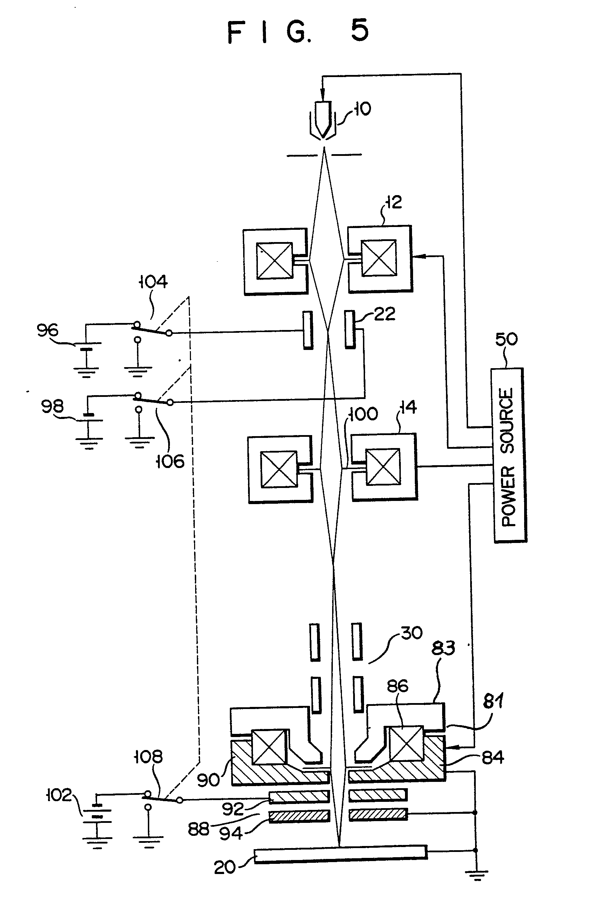

Fig. 5 is a schematic view of a lithography system according to the invention, in which the CPU and other components are the same as described in detail in connection with Figs. 1 to 3 and are omitted in Fig. 5 for reasons of convenience. In Fig. 5, like reference numerals are used to designate like members as shown in Fig. 1. The lithography system of this embodiment comprises an objective lens 81 located below the scanning deflector 30. The objective lens 81 includes an upper lens electrode 83 and a lower lens electrode 84, between which an electromagnetic coil 86 is interposed. An electrostatic lens 88 formed of a so-called Einzel lens is disposed under the objective lens 81. The electrostatic lens 88 includes first, second and third electrodes 90, 92 and 94. The electrostatic lens 88 can serve as a lens on condition that the first and third electrodes 90 and 94 have the same potential, and that the second and third electrodes 92 and 94 have different potentials. The first electrode 90 of the electrostatic lens 88 is formed integrally with the lower lens electrode 84 of the objective lens 81 and the first and third electrodes 90 and 94 of the electrostatic lens 88 are grounded.

When voltage is applied from power sources 96 and 98 to the blanking electrode 22, part of the electron beam is caused to impinge on an aperture member 100 attached to the condenser lens 14, to be intercepted by the aperture member 100. A negative voltage is supplied from a power source 102 to the second electrode 92. Numerals 104, 106 and 108 designate switches of the power sources 96, 98 and 102, respectively.

The operation of the lithography system according to this embodiment will now be described.

In delineating a pattern on the surface of the target 20, no voltage is applied to the second electrode 92 of the electrostatic lens 88. The exciting current of the condenser lens 14 is adjusted to set the spread angle of the first electron beam emitted from the electron gun 10, and the exciting current of the objective lens 81 is adjusted to focus the first electron beam on the surface of the target 20.

In exposing a background on the surface of the target 20, a predetermined negative voltage is applied to the second electrode 92 of the electrostatic lens 88. The electron beam emitted from the electron gun 10 is deflected by the effect of the electrostatic lens 88 to form a second electron beam. The second electron beam is defocussed at the surface of the target 20. In this case, moreover, voltage is applied to the blanking electrode 22, and part of the second electron beam is intercepted by the aperture member 100 of the condenser lens 14, so that the beam current of the second electron beam is reduced. Accordingly, the second electron beam with which the surface of the target 20 is exposed is greater in diameter and less in beam current than the first electron beam.

Thus, the switching between the first and second electron beams can easily be accomplished by turning the electrostatic lens 88 on or off. In doing this, the conditions of the condenser lenses 12 and 14 and the objective lens 81 undergo no change, so that the electron beam will never move nor rotate. Moreover, the lithography system of this embodiment, which can be manufactured by only adding the electrostatic lens 88 to a prior art lithography system, is simple in construction.

In this embodiment, the lithography system does not require to scan the target 20 along the same scanning line twice by using different beams. Alternatively, however, the electron beam may be applied twice to the surface of the target 20, first for the delineation of the pattern and then for the exposure of the background. The present invention may be applied not only to the raster scanning method but also to the vector scanning method. In the vector scanning method, only the peripheral region of the pattern may be exposed instead of exposing the whole background. In this embodiment according to Fig. 5, the first electrode 90 of the electrostatic lens 88 and the lower electrode 84 of the objective lens 81 are formed integrally. Alternatively, the electrostatic lens 88 may be provided independently of the objective lens 81, and its location may be changed as required. Also, a positive voltage may be applied to the second electrode 92 of the electrostatic lens 88.

## Claims

1. A system for continuously exposing desired patterns and their backgrounds on a target surface (20), comprising:
   —an electron gun (10) for emitting an electron beam;
   —blanking means (22, 100) for blanking the electron beam, which includes a blanking electrode (22) and an aperture member (100);
   —generating means (96, 98, 104, 106) for generating a blanking signal to be supplied to the blanking electrode (22), the electron beam being intercepted when the blanking signal is applied to the blanking electrode (22);
   —focussing means (12, 14, 81) for focussing the electron beam on the surface of the target (20), which includes an objective (81) and condenser lens (12, 14) for converging the electron beam on the target surface (20);
   —defocussing means (88) for defocussing the electron beam on the target surface (20); and
   —deflecting means (30) for deflecting the electron beam to scan the target surface (20) with the electron beam;
   characterized in that the generating means (96, 98, 104, 106) is capable of generating a voltage signal to be supplied to the blanking electrode (22), wherein a part of the electron beam is intercepted by the aperture member (100) attached to the condenser lens (14) when the voltage signal is applied to the blanking electrode (22) so that the beam current of the electron beam is reduced,
   in that the defocussing means (88) is located between the objective (81) and the target surface (20) and includes an electrostatic lens (88) for converging the electron beam on the target surface (20), and
   in that the defocussing means (88) is energized when the voltage signal is applied to the blanking electrode (22), the pattern being delineated by the focussed electron beam, and the background being delineated by the defocussed electron beam on the target surface (20), the switching between the focussed and the defocussed electron beam being accomplished by turning said electrostatic lens (88) on or off.

2. The system according to claim 1, characterized in that the electrostatic lens (88) comprises a first electrode (90), which functions as an electrode of the objective (81), and second and third electrodes (92, 94).

3. The system according to claim 1 or 2, characterized by second generating means (102, 108) for generating a defocussing signal to be applied to the second electrode (92) of the electrostatic lens (88).

4. The system according to claim 2 or 3, characterized in that the first and third electrodes (90, 94) of the electrostatic lens (88) are maintained at the same potential.

5. The system according to any of claims 2 to 4, characterized in that the second and third electrodes (92, 94) of the electrostatic lens (88) have different potentials.

6. The system according to any of claims 1 to 5, characterized in that the electrostatic lens (88) is an Einzel lens.

7. The system according to any of claims 1 to 6, characterized by a memory (48) containing stored pattern data, and means (44) for giving command signals to the focussing means, the defocussing means, the deflecting means and the blanking means in accordance with the data delivered from the memory (48).

## Patentansprüche

1. System zum kontinuierlichen Belichten von gewünschten Mustern und deren jeweiligem Hintergrund auf einer Targetoberfläche (20) umfassend

—Elektronenkanone (10) zum Emittieren eines Elektronenstrahls;

—eine Austasteinrichtung (22, 100) zum Austasten des Elektronenstrahles, die eine Austastelektrode (22) und ein Aperturglied (100) aufweist;

—eine Generatoreinrichtung (96, 98, 104, 106) zur Erzeugung eines Austastsignals, das der Austastelektrode (22) zuzuführen ist, wobei der Elektronenstrahl unterbrochen wird, wenn das Austastsignal an die Austastelektrode (22) angelegt wird;

—eine Fokussierungseinrichtung (12, 14, 81) zum Fokussieren des Elektronenstrahls auf die Oberfläche des Targets (20), die ein Objektiv (81) und eine Sammellinse (12, 14) aufweist, um den Elektronenstrahl auf die Targetoberfläche (20) zu bündeln;

—eine Defokussierungseinrichtung (88) zum Defokussieren des Elektronenstrahls auf der Targetoberläche (20); und

—eine Ablenkeinrichtung (30) zum Ablenken des Elektronenstrahles, um die Targetoberfläche (20) mit dem Elektronenstrahl abzutasten,

dadurch gekennzeichnet, daß die Generatoreinrichtung (96, 98, 104, 106) in der Lage ist, ein Spannungssignal zu erzeugen, das der Austastelektrode (22) zuzuführen ist, wobei ein Teil des Elektronenstrahles mit dem Aperturglied (100) unterbrochen wird, das an der Sammellinse (14) angebracht ist, wenn das Spannungssignal an die Austastelektrode (22) angelegt wird, so daß der Strahlstrom des Elektronenstrahles reduziert wird, daß die Defokussierungseinrichtung (88) sich zwischem dem Objektiv (81) und der Targetoberfläche (20) befindet und eine elektrostatische Linse (88) aufweist, um den Elektronenstrahl auf die Targetoberfläche (20) zu bündeln, und daß die Defokussierungseinrichtung (88) erregt wird, wenn das Spannungssignal an die Austastelektrode (22) angelegt wird, wobei das Muster mit dem fokussierten Elektronenstrahl gezeichnet wird und der Hintergrund mit dem defokussierten Elektronenstrahl auf der Targetoberfläche (20) gezeichnet wird, wobei die Umschaltung zwischen dem fokussierten und dem defokussierten Elektronenstrahl dadurch erfolgt, daß die elektrostatische Linse (88) eingeschaltet oder ausgeschaltet wird.

2. System nach Anspruch 1, dadurch gekennzeichnet, daß die elektrostatische Linse (88) eine erste Elektrode (90), die als eine Elektrode des Objektivs (81) arbeitet, und zweite und dritte Elektroden (92, 94) aufweist.

3. System nach Anspruch 1 oder 2, gekennzeichnet durch eine zweite Generatoreinrichtung (102, 108) zum Erzeugen eines Defokussierungssignals, das an die zweite Elektrode (92) der elektrostatischen Linse (88) anzulegen ist.

4. System nach Anspruch 2 oder 3, dadurch gekennzeichnet, daß die ersten und dritten Elektroden (90, 94) der elektrostatischen Linse (88) auf dem gleichen Potential gehalten werden.

5. System nach einem der Ansprüche 2 bis 4, dadurch gekennzeichnet, daß die zweiten und dritten Elektroden (92, 94) der elektrostatischen Linse (88) verschiedene Potentiale haben.

6. System nach einem der Ansprüche 1 bis 5, dadurch gekennzeichnet, daß die elektrostatische Linse (88) eine Einzel-Linse ist.

7. System nach einem der Ansprüche 1 bis 6, gekennzeichnet durch einen Speicher (48), der gespeicherte Musterdaten enthält, und eine Einrichtung (44) um in Abhängigkeit von den von dem Speicher (48) gelieferten Daten Steuersignal an die Fokussierungseinrichtung, die Defokussierungseinrichtung, die Ablenkeinrichtung und die Austasteinrichtung zu geben.

## Revendications

1. Un système pour exposer de façon continue des motifs désirés et leurs fonds sur une surface de cible (20), comprenant:

—un canon à électrons (10) destiné à émettre un faisceau d'électrons;

—des moyens de blocage (22, 100) destinés à bloquer le faisceau d'électrons, qui comprennent une électrode de blocage (22) et un élément à ouverture (100);

—des moyens de génération de signal (96, 98, 104, 106) destinés à produire un signal de blocage qui doit être appliqué à l'électrode de blocage (22), le faisceau d'électrons étant intercepté lorsque le signal de blocage est appliqué à l'électrode de blocage (22);

—des moyens de focalisation (12, 14, 81) destinés à focaliser le faisceau d'électrons sur la surface de la cible (20), qui comprennent un objectif (81) et un condenseur (12, 14) destinés à faire converger le faisceau d'électrons sur la surface de la cible (20);

—des moyens de défocalisation (88) destinés à défocaliser le faisceau d'électrons sur la surface de la cible (20); et

—des moyens de déflexion (30) destinés à dévier le faisceau d'électrons pour balayer la surface de la cible (20) avec le faisceau d'électrons;

caractérisé en ce que les moyens de génération de signal (96, 98, 104, 106) sont capables de produire un signal de tension à appliquer à l'électrode de blocage (22), une partie du faisceau d'électrons étant interceptée par l'élément à ouverture (100) qui est fixé au condenseur (14) lorsque le signal de tension est appliqué à l'électrode de blocage (22), afin de réduire le courant du faisceau d'électrons,

en ce que le moyens de défocalisation (88) sont placés entre l'objectif (81) et la surface de la cible (20), et ils comprennent une lentille électostatique (88) destinée à faire converger le faisceau d'électrons sur la surface de la cible (20), et en ce que les moyens de défocalisation (88) sont mis en fonction lorsque la tension de signal est appliquée à l'électrode de blocage (22), le motif étant dessiné par le faisceau d'électrons focalisé, tandis que le fond est dessiné par le faisceau d'électrons défocalisé sur la surface de la cible (20), et la commutation entre le faisceau d'électrons focalisé et le faisceau défocalisé s'effectuant par la mise en fonction ou hors fonction de la lentille électrostatique (88).

2. Le système selon la revendication 1, caractérisé en ce que la lentille électrostatique (88) comprend une première électrode (90) qui remplit la fonction d'une électrode de l'objectif (81), et des seconde et troisième électrodes (92, 94).

3. Le système selon la revendication 1 ou 2, caractérisé par des seconds moyens de génération de signal (102, 108) qui sont destinés à produire un signal de défocalisation qui est appliqué à la seconde électrode (92) de la lentille électrostatique (88).

4. Le système selon la revendication 2 ou 3, caractérisé en ce que les première et troisième électrodes (90, 94) de la lentille électrostatique (88) sont maintenues au même potentiel.

5. Le système selon l'une quelconque des revendications 2 à 4, caractérisé en ce que les seconde et troisième électrodes (92, 94) de la lentille électrostatique (88) ont des potentiels différents.

6. Le système selon l'une quelconque des revendications 1 à 5, caractérisé en ce que la lentille électrostatique (88) est une lentille d'Einzel.

7. Le système selon l'une quelconque des revendications 1 à 6, caractérisé par une mémoire (48) contenant des données de motifs enregistrées, et des moyens (44) destinés à appliquer des ordres aux moyens de focalisation, aux moyens de défocalisation, aux moyens de déflexion et au moyens de blocage, conformément aux données qui sont fournies par la mémoire (48).

F I G. 1

# F I G.   2

F I G. 3

# F I G. 4

F I G. 5